# EUROPEAN PATENT APPLICATION

(11) **EP 1 971 031 A2**
(43) Date of publication of application: **17.09.2008**
(21) Application number: 08152025.6
(22) Date of filing: 27.02.2008
(51) Int. Cl.: H03M 1/12

(54) **Circuit for programming the sampling time in a multichannel analog-to-digital converter**

(30) Priority: 14.03.2007 IT TO20070189
(71) Applicant: STMicroelectronics S.r.l., 20041 Agrate Brianza (MI) (IT)
(72) Inventor: Adamo, Santi Carlo, 95030 Catania (IT); Onde, Vincent, 13106 Rousset (FR); Bombaci, Francesco, 98125 Messina (IT)
(74) Representative: Bosotti, Luciano

(57) **Abstract**

The sampling time in a multichannel analog-to-digital converter (ADC) is programmed with a circuit comprising a memory register (10) with memory locations (SAMPLE SEL0,... , SAMPLE SEL31), which can be respectively coupled to the channels (CHO, ..., CH15) of the converter (ADC). The memory locations of the register (10) are able to store a signal identifying a sampling-time value selected for each individual channel (CHO, ..., CH15) of the converter (ADC). The circuit likewise comprises a converter module (16) coupled to the memory register (10) for converting the signal identifying the sampling-time value into a corresponding signal (*adc soc*) for driving the respective channel (CHO, ..., CH15) of the converter (ADC) for a sampling time corresponding to the sampling time selected. The circuit (10, 16) can be actuated in a synchronized way (*clk*) with the converter (ADC) so as to vary selectively the sampling time applied to the channels of the converter in the course of operation.

## Description

### Field of the invention

The invention relates to techniques for performing functions of analog-to-digital conversion, i.e., the conversion of analog signals into digital (or "numeric") signals.

### Description of the related art

Today, in the majority of microcontroller units (MCUs) a single analog-to-digital converter (ADC) is used, connected to different inputs via an analog multiplexer. The user usually has the possibility of programming a register of the sampling time with a value identical for all the analog channels of the converter. This sampling time cannot be modified during the scanning of the channels subjected to conversion.

Usually, the devices connected to the various inputs of the converter have, however, impedances that are heterogeneous with respect to one another and, consequently, would require a sampling time (i.e., a duration of the action of sampling)that is different from channel to channel.

If the user wishes to convert an individual channel, which has a particular sampling time, the user himself is able to adjust the sampling time before starting the action of conversion so as to adapt the value of the sampling time according to the output impedance of the device connected to the channel.

If, instead, it is desired to convert a number of channels operating in a scan mode, it is possible to establish an identical sampling time for all the channels subjected to conversion, without taking into account the fact that different devices with different output impedances will be connected to the various channels. In this way, the user can program the register of the sampling time so as to align it with the needs of the source that, amongst the ones connected to the converter, has the highest impedance and hence requires the longest sampling time. This gives rise to a sampling that is adapted to the worst case.

At any event, there does not exist the possibility of varying, during operation (or "run time"), the sampling time according to the channel to be converted, in particular when the various channels require different sampling times.

To mitigate this drawback, it is possible to consider converting the inputs operating by sets that have the same impedance. Clearly, this solution reduces the degree of flexibility of the scanning function.

### Object and summary of the invention

There hence exists the need to have available solutions that will enable adaptation, in particular operating during run time and/or distinctly for each individual channel, the sampling time of the channels of a multichannel analog-to-digital converter according to the channel to be converted, the aim being to achieve a greater efficiency in the selection of the sampling time and to minimize the times required for the conversion of analog inputs with different impedances when the user wishes to convert a certain set of analog channels, operating in a scan mode. The solution described herein is aimed at meeting said need.

That object is achieved thanks to a circuit having the characteristics called for in Claim 1. Advantageous developments form the subject of the dependent claims.

The claims form an integral part of the technical disclosure of the invention provided herein.

In particular, in the preferred embodiment, the circuit described herein enables programming of a sampling time for each individual channel so that, when a conversion of a sequence of channels is activated, the sampling time of each individual channel is automatically calculated by the circuit in a hardware manner.

### Brief description of the annexed figures

The invention will now be described, purely by way of non-limiting example, with reference to the annexed plate of drawings, in which:
- Figure 1 and Figure 2 are two block diagrams representing the circuit described herein and the possible integration thereof in an analog-to-digital converter ; and
- Figures 3 and 4 are timing charts representing the time evolution of signals that are generated in the operation of the circuits represented in Figures 1 and 2.

### Detailed description of an exemplary embodiment

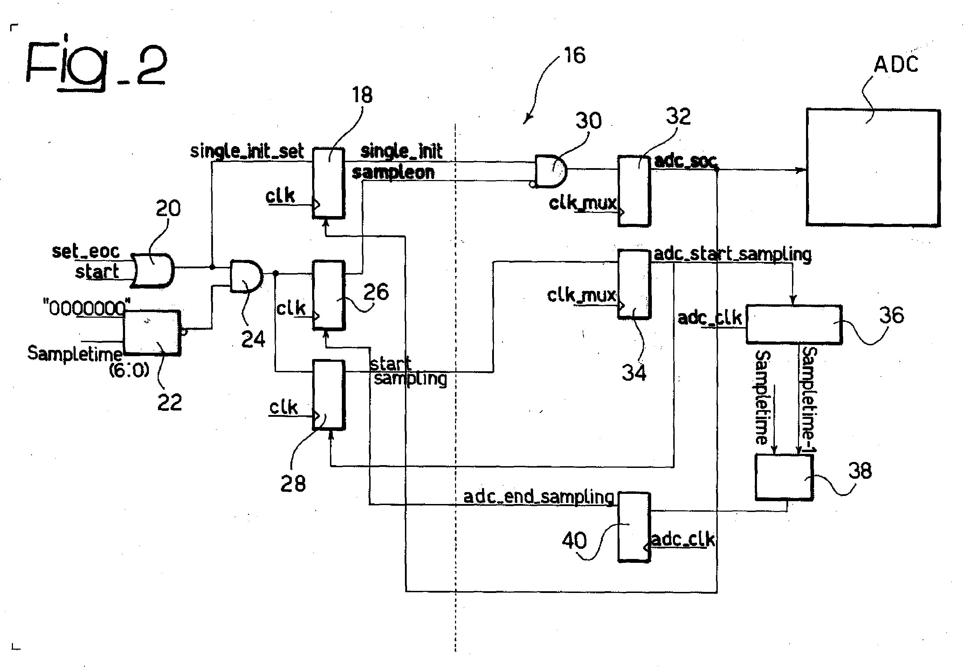

The ensuing description refers to the possible application of the circuit described herein for programming the sampling time in a 16-channel multichannel analog-to-digital converter (Figure 2). Reference to said number of channels is of course made purely by way of example.

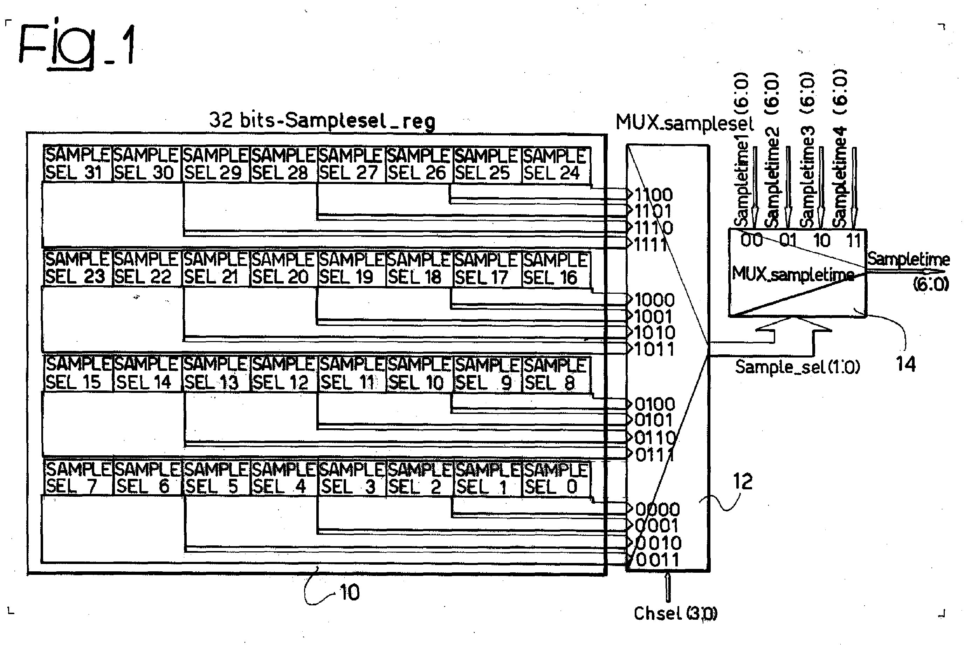

In the diagram of Figure 1, the reference 10 designates a 32-bit register that is to store the information *(samplesel_reg)* corresponding to the selection of different sampling times for the sixteen channels of the ADC. Of course, also reference to said number of bits is made purely by way of example.

The thirty-two bits of the register 10 can be viewed as organized in sixteen pairs of bits, i.e., sixteen memory locations (SAMPLE SEL0,... , SAMPLE SEL31), each of which is to store a pair of bits that enables identification (according to the logic values assumed by the two bits of the pair, i.e., 00, 01, 10, 11) of four different values of the sampling time for a respective channel from among the sixteen channels CH0, ..., CH15 of the ADC.

In the example described herein, it is assumed that the ADC is to operate according to a scan mode, i.e., activating, one after the other in cyclic and orderly sequence (the order of scanning can be possibly programmable), the sixteen channels CH0, ..., CH15 of the ADC.

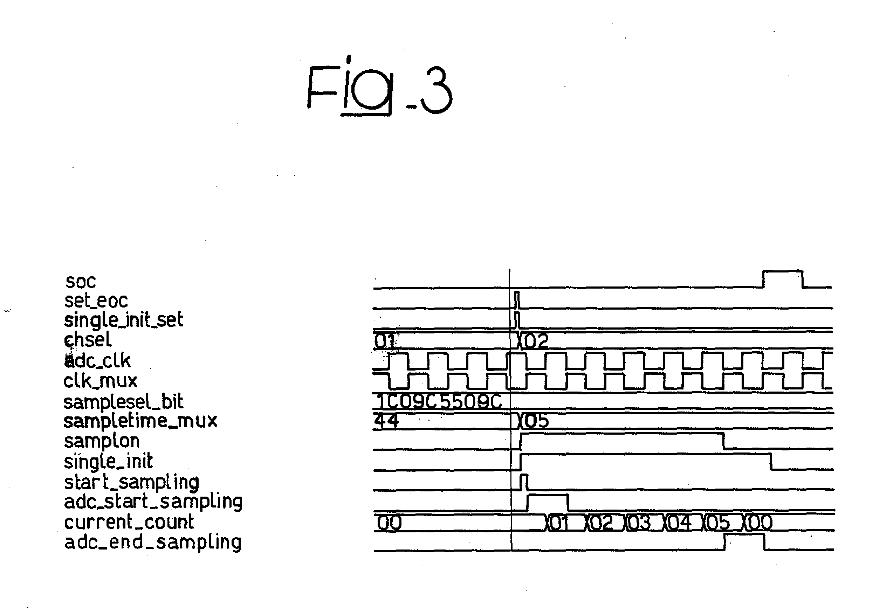

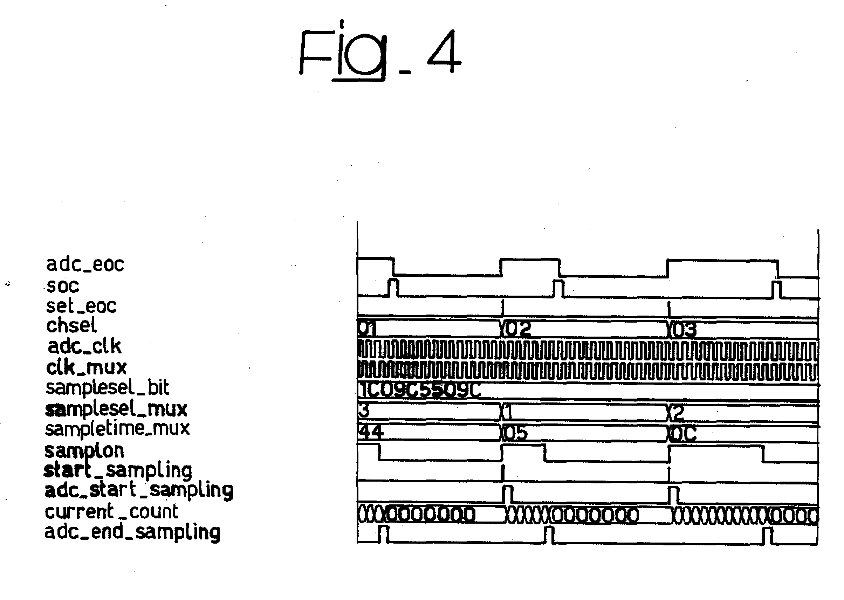

When the channel 0 (which, with reference to the timing charts of Figures 3 and 4, corresponds to the condition *chsel* = "0000") is converted, the register 10, through its position *Samplesel_reg,* brought onto the output 12 *(MUX_samplesel)* driven by a signal *chsel,* enables choice, through a multiplexer 14 *(MUX_sampletime)* driven via the signal *Sample_sel,* of the sampling time *Sampletime* for the channel 0.

In this regard, it will be appreciated that, in MUX_samplesel, 16 groups of 4 bits each are illustrated, i.e., 64 bits in all. In the example illustrated herein, the inputs of the MUX_samplesel are in fact sixteen (each made up of two bits) because, in this example, the channels of the ADC are precisely sixteen, and associated to each of them are two bits of the register 10, which in turn enable selection from among four different sampling times through MUX_sampletime (the four bits are the value of chsel corresponding to the pair selected).

The four bits on the inputs of the MUX_samplesel indicate the value of chsel that selects the desired pair of bits of the register 10.

In the example illustrated herein, where each pair of values stored in the positions of the register 10 enables identification of four different values of the sampling time, the choice of the sampling time *Sampletime* occurs between four possible choices *Sampletime1, Sampletime2, Sampletime3 and Sampletime4,* brought to the input of the multiplexer 14.

Said values can be fixed in hardware form or else rendered in turn programmable.

Proceeding in the scanning of the input channels of the ADC, the position *Samplesel_reg* of the register 10 enables choice of the sampling time for the channel CH0 and so forth up to the channel CH15.

Since operation of the register 10 is synchronized with the performance of the scan cycle of the ADC, it is timed with a clock signal *clk,* whilst the ADC (as well as the circuit as a whole designated by 16 in Figure 2) receives clock signals *adc_clk* and *clk_mux* obtained - in a known way, via a divider (not illustrated) - starting from the clock signal *clk,* dividing it in frequency by six (the factor of division can be of course different). In particular, *adc_clk* and *clk_mux* are one the negated version of the other.

The diagram of Figure 2 refers to a circuit 16, which has the function of generating, starting from the sampling-time value *Sampletime* chosen via the multiplexer 14, a corresponding signal *adc_soc* that starts the conversion of the channel of the ADC, each time involved by the action of scanning after a time equal to the sampling time selected. Added to this is the possibility of applying, in run time, to each channel CH0, ..., CH15 a different sampling time chosen from the four values *Sampletime1, Sampletime2, Sampletime3,* and *Sampletime4.*

When the analog-to-digital conversion starts operating in scan mode, a signal *start* is asserted (see once again the ensemble of the diagrams of Figures 3 and 4), and the signal *Chsel* selects the first channel of the scanning sequence to be converted, whilst, at the same time (see Figure 2), a flip-flop 18 (cadenced by the signal *clk*) is set.

In particular, the input of the flip-flop 18 is driven by a signal *single_init_set* coming from the output of an OR logic gate 20, which receives at input the signal start together with an activation signal *set_eoc.*

If, for the channel selected, the output *Sampletime* of the multiplexer 14 of Figure 1 is, for example, "0", this means that the sampling time is the minimum possible.

Specifically, the signal *Sampletime* is brought to one of the inputs of a comparator (with inverting output) 22, which receives, on its other input, the string of symbols "0000000".

The output of the OR gate 20 and the output of the comparator 22 are combined to one another in an AND gate 24, the output of which is used for driving two other flip-flops 26 and 28 (cadenced by the signal *clk),* which generate, on their outputs, a signal *sampleon* and a signal *start_sampling*, respectively.

The signal *sampleon* is brought to an inverting input of a further AND gate 30, the other input of which receives the signal *single_init* coming from the output of the flip-flop 18.

The reference numbers 32 and 34 designate another two flip-flops (both cadenced with the signal *clk*_*mux),* which receive at the input, respectively, the output of the AND gate 30 and the signal *start_sampling* at output from the flip-flop 28.

The output signal of the flip-flop 32 represents the signal *adc_soc* used for driving the sampling function of the ADC.

The output signal of the flip-flop 34 (designated by *adc_start_sampling*) is used, on the one hand, as feedback signal to the flip-flop 28 and, on the other hand, for driving a counter 36 (e.g., a 7-bit counter), cadenced with the clock signal *adc*_*clk*.

The counter 36 supplies at output a signal *Sampletime-1,* which is compared, in a comparator 38, with the reference signal *Sampletime.* The output signal of the comparator 38 is brought to a further flip-flop 40 (also cadenced with the clock signal *adc_clk*). The output of the flip-flop 40, constituted by a signal *ade_and_sampling,* is used as feedback signal to the flip-flop 26.

If, for the channel selected, the output *Sampletime* of the module 14 of Figure 1 is equal to "0" (which means that the sampling time chosen for the channel in question is the minimum possible), both of the flip-flops 26 and 28, which generate the signals *sampleon* and *start_sampling* remain reset in so far as the output of the comparator 38 is high.

In this way, the action of conversion (i.e., the interval or sampling time or interval of the ADC), represented by the signal *adc_soc,* starts on the first rising edge of the signal *clk_mux* (which, as already mentioned, constitutes the negated version of the signal *adc_clk* obtained via division by six of the main clock signal clk).

In particular, when the signal *adc_soc* is set, the flip-flop 18 that generates the signal *single_init* is reset and thus, at the subsequent rising edge of the signal *clk_mux,* the signal *adc_soc* is reset. In this way, the circuit sets its output *adc_soc* at a high level for a cycle of *adc_clk* so as to start the analog-to-digital conversion of the first channel.

The signal *clk_mux* is used for generating signals to the ADC on the falling edge of the signal *adc_clk* to prevent violations of the internal circuit of the ADC.

As may be noted in Figure 2, there are two clock domains, one on the left cadenced with the signal *clk*, and the other on the right cadenced with the clock signals *adc_clk* or *clk_mux* (which are one the negated version of the other).

If the signal *adc_clk* is asynchronous with respect to the main clock *clk*, a re-synchronization stage is used for the signals that traverse the two clock domains, without thereby altering the general structure of the circuit.

In the scan mode, after conversion of the first channel has been made, the ADC generates an end-of- conversion signal (possibly re-synchronized with the main clock signal *clk* and handled by the circuit so as to obtain the pulse signal *set_eoc*).

This signal starts conversion of the second channel of the sequence of the scan mode and has the same effect described previously on the signal *start.* The flip-flop 18 that generates the signal *single_init* is set and, if for the second channel subjected to conversion the output *Sampletime* of the module 14 of Figure 1 is different from "0", the output of the comparator 38 is at the low level so that the flip-flops 26 and 28, which generate the signals *sample_on* and *start_sampling* are set (see also Figure 3).

It will be appreciated that the signal *sample_on* constitutes a sort of masking of the signal *adc_soc*, which drives the ADC for the purpose of delaying cycles of *sampletime,* the start of the conversion of the ADC increasing the sampling time of the converter itself (see once again Figure 3).

In the case of Figure 3, the channel that is to be converted into the sequence of the scan mode is, for example, the channel 2 in so far as the selection signal *Chsel* is set at the value "0010". Consequently, the signal *samplesel_reg* is equal, for example, to the value designated by 1C09C5509Ch, which means that the signal *samplesel_reg* is equal to "01". This involves, for example, the choice - for the signal *Sampletime2 -* of a value 06h.

After the signal *start_sampling* is set, at the subsequent rising edge of the signal *clk_mux*, the flip-flop 34 that generates the signal *adc_start_sampling* is asserted so as to start the counter 36 cadenced by the signal *adc_clk*, resetting at the same time the flip-flop 28, which generates the signal *start_sampling* (usually, a handshake is envisaged between the two clock domains) .

The output of the comparator 38 goes to a high logic level when the output of the counter is equal to the value *Sampletime_1*, which indicates that the sampling is finished, determining, at the same time, setting of the flip-flop 40 that generates the signal *adc_end_sampling.*

The output of the flip-flop 40 resets the flip-flop 26 that generates the signal *sampleon* so as to demask the input of the flip-flop 32 that generates the signal *adc_soc* thus generating at the end the signal *adc_soc* on the rising edge of the signal *clk*_*mux*.

When the signal *adc*_*soc* is set, the flip-flop 18 that generates the signal *single_init* is reset and hence, at the subsequent rising edge of the signal *clk_mux,* the signal *adc_soc* is reset. In this way, the circuit 16 generates at output a high value for the signal *adc_soc* for one cycle of the signal *adc_clk* so as to start the analog-to-digital conversion of the second channel.

This procedure is repeated for all the channels in the sequence in scan mode.

It will be appreciated that the circuit solution represented herein in Figure 2 constitutes just one currently preferred embodiment of the circuit 16. Variant embodiments of the circuit 16 that enable implementation of the same function (converting the sampling-time value *Sampletime* chosen in a corresponding signal *adc_soc* that drives the channel of the ADC each time involved in the action of scanning for a time equal to the sampling time selected) are within the reach of a person skilled in the sector.

It will likewise be appreciated that the solution described herein can be extended and generalized in so far as the bit field stored in the register 10 and used for programming the sampling time can be implemented in different ways.

For example, it is possible to use a single bit per channel (so as to distinguish simply between "low" impedance and "high" impedance, i.e., between "short" sampling time and "long" sampling time), two bits per channel (as previously described in the example), n bits according to a linear law, (for example, 1, 2, 3, 4, 5,....), or else n bits according to a non-linear law (for example an exponential law: 1, 2, 4, 8, 16, ...).

The solution described herein enables then dynamic adjustment, according to the channel to be converted, of the scanning time so as to obtain a greater efficiency and minimize the time occupied in the conversion of a number of analog inputs when a user wishes to convert a group of analog channels operating in scan mode.

Of course, without prejudice to the principle of the invention, the details of construction and the embodiments may vary, even to a major extent, with respect to what is described and illustrated herein purely by way of non-limiting example, without thereby departing from the scope of the present invention, as defined by the annexed claims.

## Claims

1. A circuit for programming the sampling time in an analog-to-digital converter (ADC) comprising a plurality of channels, **characterized in that** the circuit comprises:
- at least one memory register (10) comprising memory locations (SAMPLE SEL0,... , SAMPLE SEL31), respectively, coupleable to the channels (CHO, ..., CH15) of the converter (ADC); said memory locations configured for storing a signal identifying a sampling-time value selected for the respective channel (CHO, ..., CH15) of the converter (ADC); and
- a converter module (16), coupled to said at least one memory register (10) for converting said signal identifying the sampling-time value into a corresponding signal (*adc_soc)* for driving the respective channel (CHO, ..., CH15) of the converter (ADC) with a sampling time corresponding to the sampling time selected for the respective channel (CHO, ..., CH15) of the converter (ADC).

2. The circuit according to Claim 1, in which said sampling time is programmable for each individual channel in said analog-to-digital converter (ADC).

3. The circuit according to Claim 1 or Claim 2, wherein said memory locations (SAMPLE SEL0,... , SAMPLE SEL31) are configured for storing at least one bit identifying two different values for the sampling time selected for the respective channel (CHO, ..., CH15) of the converter (ADC).

4. The circuit according to Claim 1, wherein said memory locations (SAMPLE SEL0,... , SAMPLE SEL31) are configured for storing at least two bits identifying four different values for the sampling time selected for the respective channel (CHO, ..., CH15) of the converter (ADC).

5. The circuit according to Claim 1, wherein said memory locations (SAMPLE SEL0,... , SAMPLE SEL31) are configured for storing a plurality of bits identifying different values for the sampling time selected for the respective channel (CH0, ..., CH15) of the converter (ADC), said different values being ordered according to a linear scale.

6. The circuit according to Claim 1, wherein said memory locations (SAMPLE SEL0,... , SAMPLE SEL31) are configured for storing a plurality of bits identifying different values for the sampling time selected for the respective channel (CH0, ..., CH15) of the converter (ADC), said different values being ordered according to a non-linear scale, for example exponential.

7. The circuit according to any one of the preceding claims, comprising a multiplexer module (14) for receiving at input a plurality of signals (*Sampletime 1, Sampletime 2, Sampletime 3, Sampletime* 4) representing different values of sampling time for the channels (CHO, ..., CH15) of said converter (ADC), said multiplexer module (14) coupled to said at least one memory register (10) for transferring selectively to said converter module (16), according to an identifying signal, each time read by one of said memory locations (SAMPLE SEL0,... , SAMPLE SEL31), one from among said signals *(Sampletime 1, Sampletime 2, Sampletime* 3, *Sampletime* 4) representing different values of sampling time for the channels (CHO, ..., CH15) of said converter (ADC).

8. The circuit according to Claim 6, wherein said plurality of signals *(Sampletime 1, Sampletime 2, Sampletime* 3, *Sampletime* 4) represent different values of sampling time for the channels (CHO, ..., CH15) of said converter (ADC) are fixed via hardware.

9. The circuit according to any one of the preceding claims for programming the sampling time in an analog-to-digital converter (ADC) that performs the conversion on said plurality of channels in a scan mode, wherein the circuit (10, 16) is actuatable in a synchronized way (*clk*) with said analog-to-digital converter (ADC) so as to be able to vary selectively the sampling-time value applied to the channels of the analog-to-digital converter (ADC) in the course of said scanning operation.
